# EUROPÄISCHE PATENTSCHRIFT

(11) **EP 1 213 424 B1**
(45) Veröffentlichungstag und Bekanntmachung des Hinweises auf die Patenterteilung: **18.01.2006**
(21) Anmeldenummer: 01127606.0
(22) Anmeldetag: 20.11.2001
(51) Int. Cl.: E05C 1/04

(54) **Mehrteiliges Gehäuse mit einer Vorrichtung zum Verriegeln der Gehäuseteile**
Multi-part housing with a device for locking the housing parts
Boîtier à multiples parties avec un dispositif pour le verrouillage des parties de boîtier

(30) Priorität: 07.12.2000 DE 20020983 U
(43) Veröffentlichungstag der Anmeldung: 12.06.2002
(73) Patentinhaber: DeTeWe Systems GmbH, 10997 Berlin (DE)
(72) Erfinder: Krispin, Harro, 13503 Berlin (DE)
(74) Vertreter: Fischer, Uwe

(56) Entgegenhaltungen:
- WO-A-00/53506
- CA-A- 2 036 939
- US-A- 2 103 989
- US-A- 5 121 952
- US-A- 5 664 812

## Beschreibung

Die Erfindung zieht sich auf ein mehrteiliges Gehäuse mit einer Vorrichtung zum Verriegeln von miteinander verbundenen Gehäuseteilen des mehrteiligen Gehäuses für elektrische und elektronische Bauelemente gemäß dem Oberbegriff des Anspruchs 1.

Gehäuse für elektrische und elektronische Bauelemente, insbesondere Gehäuse für Telekommunikationsanlagen, dienen zum Schutz der elektrischen und elektronischen Bauelemente vor Beschädigung und Verschmutzung sowie gegen unbefugte Eingriffe, die zur Zerstörung oder Funktionsbeeinträchtigung der elektrischen oder elektronischen Bauelemente bzw. der Einrichtung führen können.

Aus der DE 92 03 115 U1 ist ein Gehäuse für eine Telekommunikationsanlage in Form einer Fernsprechnebenstellenanlage bekannt, das aus einem Gehäuseunterteil zur Aufnahme der elektronischen Bauteile und Anschlussklemmen sowie mit einer gegen unbefugtes Öffnen gesicherten Abdeckhaube besteht. Um zu vermeiden, dass die Abdeckhaube nur mit einem Spezialwerkzeug geöffnet werden kann, weist die Abdeckhaube an einer Längsseite Rastorgane auf, die mit komplementären Rastorganen des Unterteils zusammenwirken und die Abdeckhaube im aufgesetzten Zustand an der einen Längsseite verriegeln.

Das Unterteil weist an der gegenüberliegenden Längsseite einen federnden und in Richtung zur Innenseite der zugeordneten Abdeckhauben-Seitenwand weisenden Sperrhaken auf, der nach dem Aufdrücken der Abdeckhaube in eine innere Ausnehmung der Seitenwand eindringt und die Abdeckhaube verriegelt. Weiterhin weist der Sperrhaken eine mit einer Öffnung versehene Lasche auf, während das Unterteil im Bereich der Lasche eine Öffnung besitzt, die das Einführen eines Werkzeugs in die Öffnung der Lasche ermöglicht, so dass der Sperrhaken aus der Ausnehmung gehebelt werden kann und die Abdeckhaube freigibt.

Die bekannte Vorrichtung zum Verbinden und Verriegeln einer Abdeckhaube an einem Gehäuseunterteil ist aufwendig konstruiert und erfordert eine vergleichsweise umständliche Handhabung beim Entriegeln der Abdeckhaube unter Einsatz eines hierfür notwendigen Werkzeugs. Zudem eignet sich die bekannte Verriegelungsvorrichtung nur für jeweils bestimmte Gehäusegrößen und -formen, da eine exakte Abstimmung zwischen dem Sperrhaken und der Öffnung im Gehäuseunterteil erforderlich ist.

Aus der US-Patentschrift 5,121,952 ist eine Vorrichtung mit einem Verriegelungselement bekannt, das zwei zu verbindende Teile miteinander verriegelt. Eines der zu verbindenden Teile weist eine schlitzförmige Öffnung auf, in die das Verriegelungselement derart eingesetzt ist, dass es die schlitzförmige Öffnung durchgreift. Das Verriegelungselement kann in der schlitzförmigen Öffnung in eine Verriegelungsstellung gebracht werden, in der es die beiden zu verbindenden Teile verbindet und somit miteinander verriegelt. Mit dem Verriegelungselement wirkt ein Sperrelement zusammen, dass die Verstellbarkeit des Verriegelungselementes in der Verriegelungsstellung blockiert; das Sperrelement ist dabei derart ausgestaltet, dass es ein Verschieben des Verriegelungselementes in der schlitzförmigen Öffnung dadurch unterbindet, dass es an einem Ende der schlitzförmigen Öffnung in blockierender Weise anliegt.

Aufgabe der vorliegenden Erfindung ist es, ein mehrteiliges Gehäuse mit einer Vorrichtung zum Verriegeln von miteinander verbundenen Gehäuseteilen des mehrteiligen Gehäuses zu schaffen, die leicht herstell- und montierbar ist, die sich durch eine universelle Verwendbarkeit für unterschiedliche Gehäusegrößen und -formen auszeichnet und deren Verriegelung leicht und sicher sowie ohne die Anwendung von Spezialwerkzeugen sperrbar ist.

Diese Aufgabe wird erfindungsgemäß durch die Merkmale des Anspruchs 1 gelöst.

Die erfindungsgemäße Lösung ist leicht herstellbar und montierbar, da nicht die Einhaltung besonderer Toleranzen erforderlich ist und die Verriegelungs- und Sperrfunktion voneinander getrennt sind. Aufgrund ihres einfachen Mechanismus ist die erfindungsgemäße Verriegelungs- und Sperrvorrichtung universell für unterschiedliche Gehäusegrößen und -formen verwendbar und die Verriegelung kann leicht und sicher ohne die Notwendigkeit von Spezialwerkzeugen gesperrt werden, da die Funktionstrennung von Verriegeln und Sperren die Möglichkeit bietet, das Sperren der Verriegelungsvorrichtung nur in bestimmten Positionen vornehmen zu können, in denen die Gehäuseteile entweder vollständig verriegelt oder zum Trennen der Gehäuseteile vollständig entriegelt sind. Ebenfalls aufgrund der Funktionstrennung kann die Sperrvorrichtung so gestaltet werden, dass sie ohne Spezialwerkzeuge bedienbar ist, die Sperrfunktion aber nicht durch unbeabsichtigte Handhabung aufgehoben werden kann.

Erfindungsgemäß ist das Verriegelungselement in Längsrichtung verschiebbar, formschlüssig in eine schlitzförmige Öffnung des ersten Gehäuseteils eingesetzt, während das Sperrelement Teile des Verriegelungselementes zur kraftschlüssigen Anlage an Abschnitte der im Wesentlichen parallel zueinander in Verschieberichtung des Verriegelungselements verlaufenden seitlichen Öffnungsränder der Öffnung des ersten Gehäuseteils bringt.

Ein zumindest kraftschlüssiges Sperren der. Verschiebemöglichkeit des Verriegelungselements ermöglicht ein Blockieren des Verriegelungselements in jeder Stellung auf dessen Verschiebeweg innerhalb der Öffnung des ersten Gehäuseteils und gewährleistet eine einfache Konstruktion des Sperrelements zum Erfüllen der Sperrfunktion.

Das Verriegelungselement weist eine an der Außenwand des ersten Gehäuseteils anliegende Betätigungsfläche und einen die Öffnung des ersten Gehäuseteils durchgreifenden Gleit- und Arretierungskörper auf, der als Hohlkörper mit an den seitlichen Öffnungsrändern der Öffnung im ersten Gehäuseteil anliegenden Gleitelementen ausgebildet ist, die Teil von Wandabschnitten des Gleit-und Arretierungskörpers sind, die parallel zu den seitlichen Öffnungsrändern der Öffnung des ersten Gehäuseteils verlaufen.

Diese Ausgestaltung des Verriegelungselements ermöglicht zum einen eine einfache Konstruktion und Verbindung des Verriegelungselements mit dem betreffenden Gehäuseteil und schafft die Voraussetzung für eine einfache und platzsparende Unterbringung des Sperrelements.

Zu diesem Zweck sind die Wandabschnitte des Gleit- und Arretierungskörpers senkrecht zur Verschieberichtung beweglich, während das in das Verriegelungselement eingesetzte Sperrelement in der Verriegelungsstellung die Gleitelemente der beweglichen Wandabschnitte kraftschlüssig zur Anlage an die seitlichen Öffnungsränder bringt.

Zur Verstärkung der Sperrwirkung und zur Gewährleistung, dass die Sperrfunktion nur in definierten Stellungen des Verriegelungselements aktivierbar ist, insbesondere in der Verriegelungs- und der Entriegelungsstellung, sind die beweglichen Wandabschnitte des Gleit- und Arretierungskörpers mit Rastvorsprüngen derart versehen, dass beim Einstecken des Gleit- und Arretierungskörpers in die Öffnung des ersten Gehäuseteils die beweglichen Wandabschnitte an den seitlichen Öffnungsrändern entlanggleiten und nach dem Überwinden der Rastvorsprünge das Verriegelungselement formschlüssig mit dem ersten Gehäuseteil verbunden ist und die Gleitelemente an den seitlichen Öffnungsrändern anliegen, so dass die als Gleitstege ausgebildeten Gleitelemente in vorgegebenen Stellungen des Verriegelungselements in Einkerbungen der seitlichen Öffnungsränder der Öffnung im ersten Gehäuseteil einrasten.

Vorzugsweise sind die Gleitstege in der Mitte des Verriegelungselements und die Einkerbungen so in den seitlichen Öffnungsrändern angeordnet, dass die Gleitstege in der Verriegelungs- und Entriegelungsstellung des Verriegelungselements in die Einkerbungen einrasten.

Um eine einfache Bedienung des Sperrelements zu ermöglichen und gleichzeitig ein unbeabsichtigtes und unbefugtes Öffnen des, Gehäuses auszuschließen bzw. zu erschweren, ist in der Betätigungsfläche des Verriegelungselements ein Verstellteil des als Drehriegel ausgebildeten Sperrelements angeordnet, und eine senkrecht von der Betätigungsfläche des Verriegelungselements abstehende Drehachse des Sperrelements ist mit seitlichen, durch Verdrehen des Verstellteils in Anlage an die beweglichen Wandabschnitte des Gleit- und Arretierungskörpers bringbaren Klemmstegen versehen.

Um eine Fehlbedienung des Sperrelements durch dessen Betätigung in nicht definierten Stellungen auszuschließen, ist das Verstellteil des Drehriegels nur dann in die Verriegelungsstellung der Verriegelungsvorrichtung bringbar, wenn die Gleitstege in eine der Einkerbungen der seitlichen Öffnungsränder in der Gehäuseöffnung eingerastet sind.

Zur Schaffung eines gefälligen Aussehens und zur Vermeidung einer von der Gehäusewand abstehenden Verriegelungsvorrichtung, wird die Betätigungsfläche des Verriegelungselements in eine Vertiefung der an die Öffnung angrenzenden Wandabschnitte des ersten Gehäuseteils eingesetzt.

Dem gleichen Zweck dient eine Vertiefung in der Betätigungsfläche des Verriegelungselements zur Aufnahme des kreisscheibenförmig ausgebildeten und mit einem mittig angeordneten Betätigungsschlitz oder -steg versehenen Verstellteils des Sperrelements.

Um eine leichte Montage des Verriegelungs- und Sperrelements zu gewährleisten, und eine definierte Zuordnung zwischen dem Verriegelungselement und dem Sperrelement zu schaffen, weist die Betätigungsfläche des Verriegelungselements eine Schlüssellochöffnung zur Aufnahme der Drehachse und der Klemmstege des Sperrelements auf, wobei die Schlüssellochöffnung diagonal zu den beweglichen Wandabschnitten des Verriegelungselements ausgerichtet ist.

Einer einfachen Montage des Verriegelungs- und des Sperrelements dient eine solche Ausgestaltung des Sperrelements, dass keine vorherige Ausrichtung des Sperrelements in Bezug auf das Verriegelungselement erforderlich ist, um beide Teile miteinander zu verbinden. Zu diesem Zweck weist die Unterseite des Verstellteils mindestens eine mit den entgegengesetzt zueinander von der Drehachse abstehenden Klemmstegen fluchtende Nase aufweist und die Vertiefung der Betätigungsfläche zur Aufnahme des Verstellteils enthält eine teilkreisförmige Nut, in die die Nase an der Unterseite des Verstellteils eingreift.

Weiterhin ist in der teilkreisförmigen Nut ein Steg angeordnet ist, der die teilkreisförmige Nut in einen mit der Schlüssellochöffnung im Wesentlichen fluchtenden Einsetzbereich für die Nase und in einen Verstellbereich für das Sperrelement unterteilt, wobei der Steg eine dem Einsetzbereich zugewandte Schrägfläche und eine dem Verstellbereich zugewandte senkrechte Fläche aufweist, derart, dass nach dem Einsetzen des Sperrelements in das Verriegelungselement und dem Überwinden des Steges das Sperrelement um das Winkelmaß des Verstellbereiches zwischen der Verriegelungs- und der Entriegelungsstellung verstellbar ist.

Durch diese Konstruktion der Aufnahmefläche des Verriegelungselements in Verbindung mit der Korifiguration des Sperrelements kann das Sperrelement in beliebiger Ausrichtung in das Verriegelungselement eingesetzt werden, wobei die Schlüssellochöffnung des Verriegelungselements in Verbindung mit den Klemmstegen des Sperrelements die Einsetzrichtung vorgibt, die Ausrichtung des Sperrelements aber beliebig ist.

Da die Klemmstege, des Verstellteils nach einem weiteren bevorzugten Ausführungsform der Erfindung zumindest um das Maß der Tiefe der Schlüssellochöffnung der Betätigungsfläche von der Unterseite des Verstellteils beabstandet sind, wird nach einer geringfügigen Drehung des Sperrelements durch Überwinden des Steges das Sperrelement in Funktionsbereitschaft gebracht und sicher mit dem Verriegelungselement verbunden.

Um spürbar das Erreichen der Verriegelungs- und der Entriegelungsstellung zu gestalten, sind beide Endstellungen durch abgerundete Vorsprünge innerhalb des Verstellbereichs festgelegt.

Die nicht in den Verstellbereich eingreifende zweite Nase an der Unterseite des Verstellteils des Sperrelements ist freibeweglich in einem Leerlaufbereich in der Betätigungsfläche des Verriegelungselements angeordnet und damit funktionslos, ohne die Wirkung des Sperrelements zu behindern.

Schließlich sind zur Erleichterung des Verschiebens des Verriegelungselements an die Vertiefung zur Aufnahme des Verstellteils des Sperrelements angrenzende Fingermulden in der Betätigungsfläche des Verriegelungselements vorgesehen.

Anhand eines in der Zeichnung dargestellten Ausführungsbeispiels soll der der Erfindung zugrundeliegende Gedanke näher erläutert werden. Es zeigen:
- Figur 1 -: eine perspektivische Darstellung eines modular aufgebauten Gehäuses einer Telekommunikationsanlage;
- Figur 2 -: eine Seitenansicht des Gehäuseunterteils;
- Figur 3 -: eine perspektivische Innenseitenansicht eines Seitenteils der Abdeckhaube;
- Figur 4 -: eine Ansicht der Abdeckhaubenöffnung zur Aufnahme des Verriegelungs- und Sperrelements;
- Figur 5 -: eine perspektivische Darstellung eines Verriegelungselements und eines hierzu gehörigen Sperrelements;
- Figur 6 -: eine isolierte perspektivische Darstellung des Verriegelungselements;
- Figuren 7 bis 10 -: verschiedene Ansichten des Verriegelungselements gemäß Figur 6;
- Figur 11 -: eine isolierte perspektivische Darstellung des Sperrelements und
- Figuren 12 bis 14 -: verschiedene Ansichten des Sperrelements gemäß Figur 11.

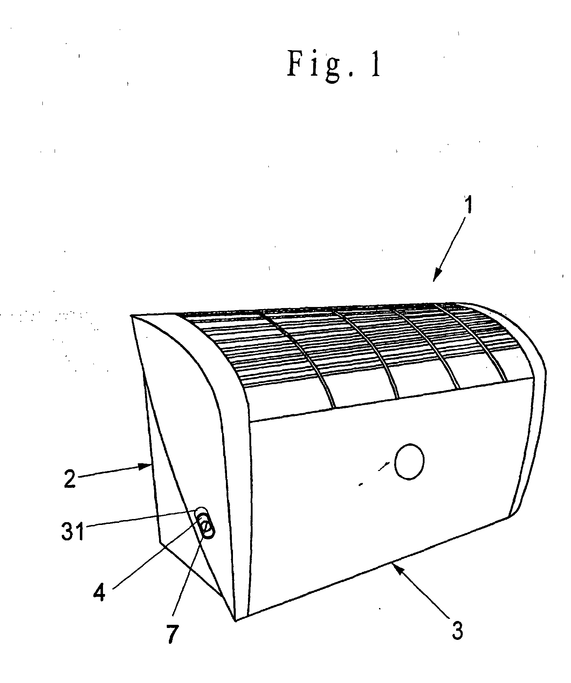

Figur 1 zeigt in perspektivischer Ansicht ein Gehäuse 1 für eine Telekommunikationsanlage zur Aufnahme und Abdeckung elektrischer und elektronischer Bauteile, Verbindungsleitungen und Anschlußklemmen. Das Gehäuse 1 besteht aus einem Gehäuseboden oder Gehäuseunterteil 2, das für eine wahlweise Wandbefestigung des Gehäuses 1 entsprechende Öffnungen oder Vorsprünge aufweist. Der Gehäuseboden 2 kann mit einem Baugruppenrahmen, beispielsweise einem 19-Zoll- oder ET-SI-Baugruppenrahmen, zur Aufnahme der elektrischen und elektronischen Bauteile, insbesondere zur Aufnahme von Steckkarten mit darauf angeordneten elektronischen Bauelementen, Steckbuchsen sowie einer Haltung für eine Stromversorgung verbunden werden.

Zur Abdeckung des mit dem Gehäuseboden 2 verbundenen Baugruppenrahmens oder -trägers bzw. der Stecker, elektrischen und elektronischen Bauelemente sowie der Stromversorgungseinrichtung dient eine Abdeckhaube 3, die auf den Gehäuseboden 2 vorzugsweise formschlüssig aufgesetzt und mit dem Gehäuseboden 2 verbunden wird. Zum Verriegeln der Verbindung zwischen dem Gehäuseboden 2 und der Abdeckhaube 3 dient ein in eine Öffnung der Abdeckhaube 3 einsetzbares Verriegelungselement 4, das mit einem Sperrelement 7 zum Blockieren der Stellung des Verriegelungselements 4 zumindest in der Verriegelungsstellung und vorzugsweise in der Entriegelungsstellung zwischen Abdeckhaube 3 und Gehäuseboden 2 verbunden wird.

Das Verriegelungs- und Sperrelement 4, 7 kann wahlweise an einer Seitenwand der Abdeckhaube 3 oder an beiden Seitenwänden bzw. auch an der Frontseite, der Unter- oder Oberseite des Gehäuses 1 angebracht werden, wenn der Gehäuseboden 2 eine entsprechende Verbindungsmöglichkeit aufweist, in die das entsprechend angeordnete Verriegelungselement 4 form- und/oder kraftschlüssig eingreifen kann.

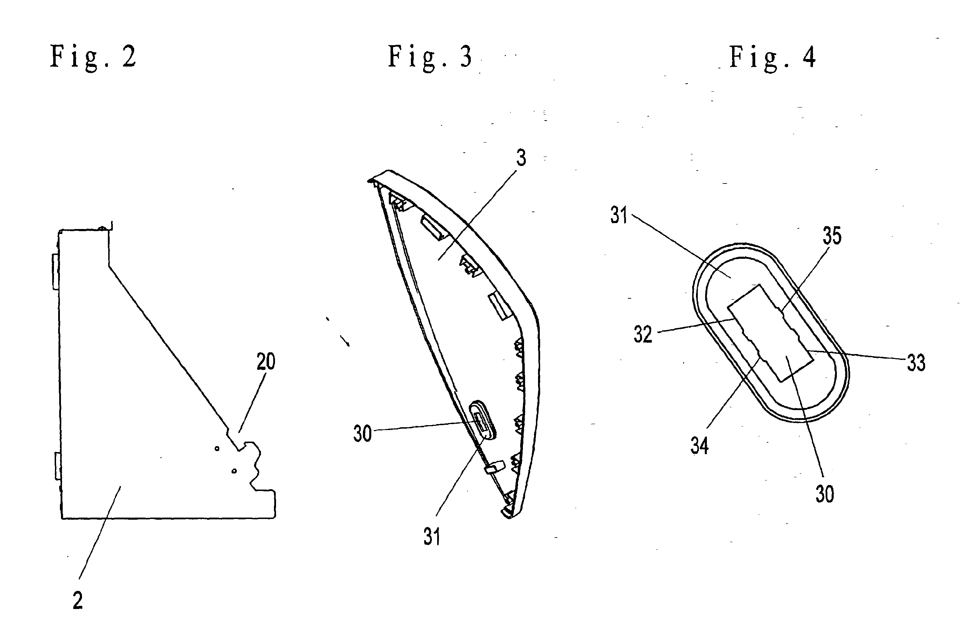

In dem hier dargestellten Ausführungsbeispiel ist zur Arretierung und Verbindung der Abdeckhaube 3 mit dem Gehäuseboden 2 ein Verriegelungselement 4 an beiden Seiten der Abdeckhaube 3 vorgesehen, das im verriegelten Zustand von Abdeckhaube 3 und Gehäuseboden 2 bei einem gemäß Figur 2 ausgebildeten Seitenteil des Gehäusebodens 2 hinter eine Hinterschneidung 20 des Seitenteils greift. Zum Entriegeln wird das Verriegelungselement 4 aus der Hinterschneidung 20 herausbewegt, so daß die Abdeckhaube 3 vom Gehäuseboden 2 abgenommen werden kann.

Das Verriegelungselement 4 ist in einer als Mulde ausgebildeten Vertiefung 31 des Seitenteils der Abdeckhaube 3 angeordnet, die eine Öffnung 30 umgibt, durch die entsprechende Verriegelungsteile des Verriegelungselements 4 gesteckt werden, die zum Verriegeln von Abdeckhaube 3 und Gehäuseboden 2 in Eingriff mit der Hinterschneidung 20 des Seitenteils des Gehäusebodens 2 treten.

Figur 4 zeigt eine Detailansicht des Bereichs der Seitenwand der Abdeckhaube 3, der zur Aufnahme des Verriegelungselements 4 und Sperrelements 7 dient. Die in der Mulde oder Vertiefung 31 vorgesehene Öffnung 30 weist zwei parallele seitlichen Öffnungsränder 32, 33 auf, die durch nicht näher bezeichnete stirnseitige Ränder die Öffnung 30 bilden. In den seitlichen Öffnungsrändern 32, 33 der Öffnung 30 sind einander gegenüberliegend jeweils zwei Einkerbungen 34, 35 vorgesehen, die - wie nachfolgend dargestellt wird - in Verbindung mit einem Gleitsteg des Verrieglungselements 4 ein Einrasten des Verriegelungselements 4 in vorbestimmten Positionen längs des Verschiebeweges des Verriegelungselements 4 zur Festlegung der Verriegelungs- und Entriegelungsstellung dienen.

Die Vertiefung oder Mulde 31 dient in Verbindung mit einer entsprechenden Formgebung einer Betätigungsfläche des Verriegelungselements 4 einem bündigen Abschluß der Verriegelungs- und Sperrvorrichtung mit der Außenwand der Abdeckhaube 3, so dass keine vorspringenden Teile den Gesamteindruck stören und eine unbeabsichtigte Beschädigung der Verriegelungs- und Sperrvorrichtung vermieden wird.

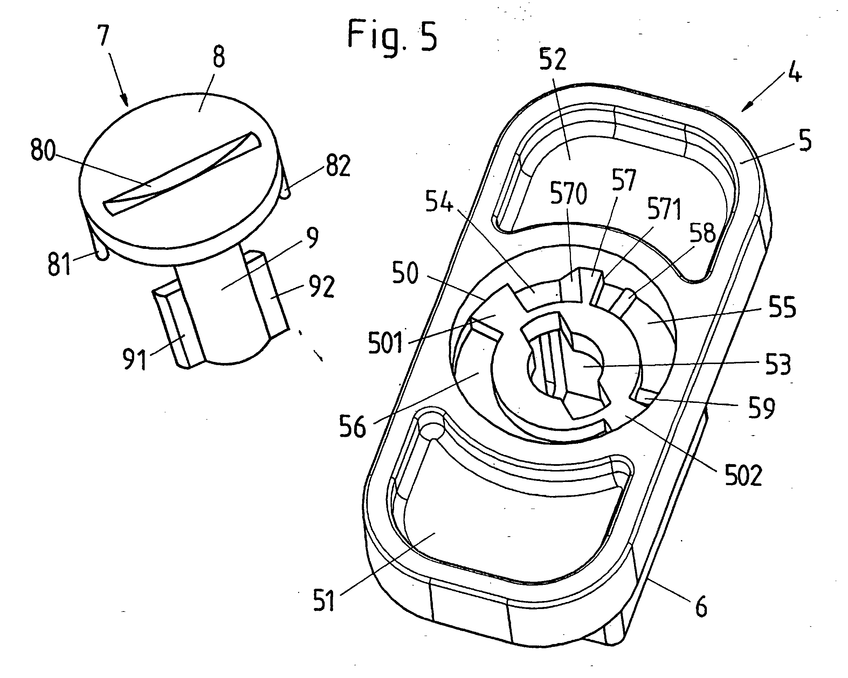

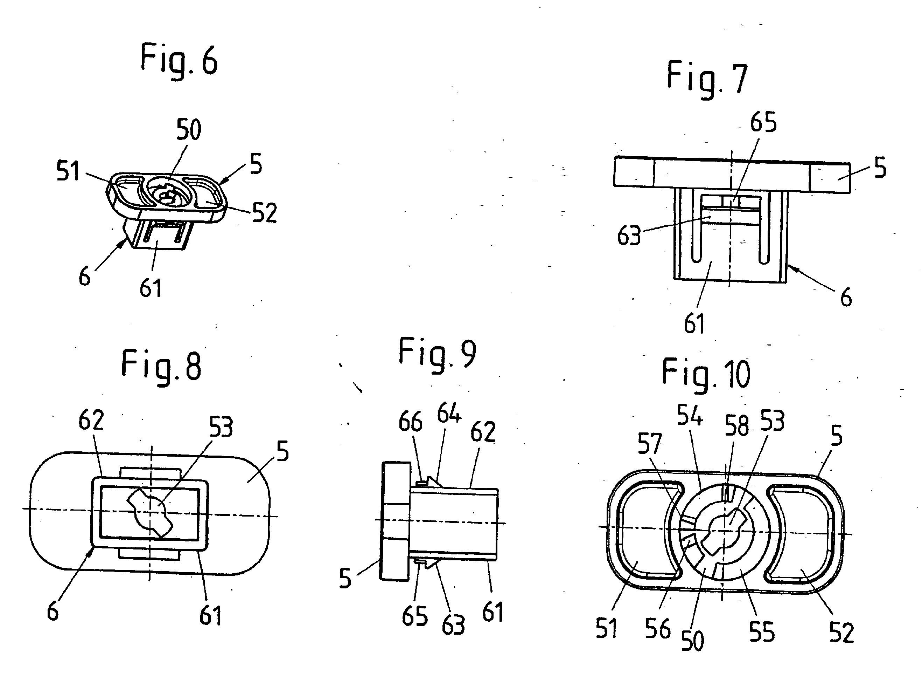

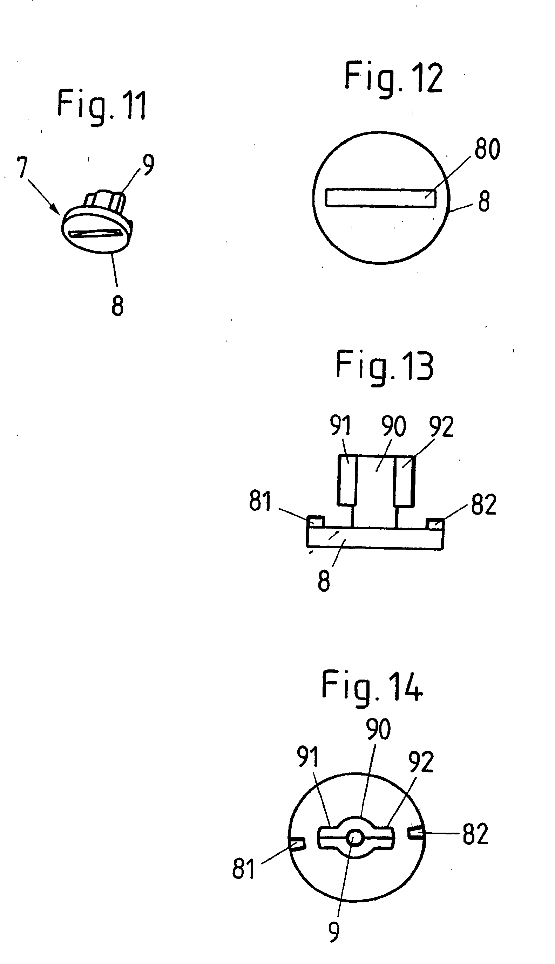

Die nachfolgende Beschreibung des Aufbaus und der Funktion des Verriegelungselements 4 und des Sperrelements 7 erfolgt unter Bezugnahme auf sämtliche Figuren 5 bis 14, die den Zusammenhang zwischen dem Verriegelungselement 4 und der Öffnung 30 in der Wand der Abdeckhaube 3 einerseits und dem Verriegelungselement 4 und dem Sperrelement 7 andererseits sowie konstruktive Einzelheiten des Verriegelungselements 4 und des Sperrelements 7 verdeutlichen.

Das Verriegelungselement 4 weist eine Betätigungsfläche 5 auf, deren äußere kontur der Vertiefung 31 in der Seitenwand der Abdeckhaube angepaßt ist und ein Längsverschieben des Verriegelungselements 4 innerhalb der Vertiefung 31 ermöglicht. Zum Längsverschieben des Verriegelungselements 4 dienen Fingermulden 51, 52 in der Oberfläche der Betätigungsfläche 5, zwischen denen eine kreisförmige Vertiefung 50 zur Aufnahme eines Verstellteils 8 des Sperrelements 7 vorgesehen ist. Mittig innerhalb der kreisförmigen Vertiefung 50 ist eine Schlüssellochöffnung 53 angeordnet, durch die eine Drehachse 9 mit diametral zueinander angeordneten Klemmstegen 91, 92 des Sperrelements 7 steckbar ist.

Die Vertiefung 50 in der Betätigungsfläche 5 des Verriegelungselements 4 weist eine erste teilkreisförmige Nut 54, 55 sowie eine zweite teilkreisförmige Nut 56 auf, die durch Trennstege 501, 502 voneinander getrennt sind, so daß zwischen den Trennstegen 501, 502 die Symmetrielinie zwischen der ersten und zweiten Nut 54, 55 bzw. 56 verläuft.

In der teilkreisförmigen Nut 54, 55 ist ein Steg 57 vorgesehen, der die Nut 54, 55 in einen Einsetzbereich 54 und einen Verstellbereich 55 aufteilt. An der Unterseite des Verstellteils 8 des Sperrelements 7 sind einander gegenüberliegend an den Rändern des Verstellteils 8 Vorsprünge bzw. Nasen 81, 82 vorgesehen, die in Bezug auf die Klemmstege 91, 92 an der Drehachse 9 des Sperrelements 7 in einer Ebene angeordnet sind. Dadurch greift beim Einsetzen des Sperrelements 7 in die Vertiefung 50 der Betätigungsfläche 5 des Verriegelungselements 4 aufgrund der Ausrichtung der Schlüssellochöffnung 53 in der Vertiefung 50 und der entsprechenden Zuordnung der Klemmstege 91, 92 des Sperrelements 7 jeweils eine der beiden Nasen 81, 82 in den Einsetzbereich 54 ein, während die andere Nase in die teilkreisförmige Nut 56 eingreift.

Wenn die Verstellfläche 8 des Sperrelements 7 bündig in die kreisförmige Ausnehmung 50 des Betätigungsfläche 5 eingesetzt ist, befinden sich die Klemmstege 91, 92 mit ihrem oberen, der Verstellfläche 8 zugewandten Ende etwas unterhalb der Schlüssellochöffnung 53. Durch Verdrehen des Sperrelements 7 beispielsweise mit Hilfe eines in der Verstellfläche 8 vorgesehenen Schlitzes 80 wird die im Einsetzbereich 54 befindliche Nase 81 oder 82 des Sperrelements 7 an einer schrägen Fläche 570 des Steges 57 entlanggleitend angehoben, wobei infolge der Drehbewegung die Klemmstege 91, 92 nicht mehr mit der Schlüssellochöffnung 53 fluchten und somit ein Herausfallen des Sperrelements 7 aus dem Verriegelungselement 4 verhindern.

Bei weiterem Verdrehen des sperrelements 7 springt die betreffende Nase 81 oder 82 über den Steg 57 und gelangt in den Verstellbereich 55. In dieser Stellung kann das Sperrelement 7 nicht mehr aus dem Verriegelungselement 4 herausgenommen werden, da eine im wesentlichen senkrechte Fläche 571 des Steges 57 ein entsprechendes Herauslösen des Sperrelements 7 aus der Vertiefung 50 des Verriegelungselements verhindert.

Innerhalb des Verstellweges des Verstellbereichs 55 sind nockenförmigen Erhebungen 58, 59 vorgesehen, die eine spürbare Schaltbewegung bewirken und somit die jeweiligen Endstellungen des Sperrelements 7 fühlbar machen, in denen die Verriegelungs- und Entriegelungsstellung vorliegen.

Die formschlüssige Verbindung zwischen dem Verriegelungselement und der Abdeckhaube 3 wird durch einen Gleit- und Arretierungskörper 6 des Verriegelungselements 4 hergestellt, der kastenförmig und als Hohlkörper ausgebildet senkrecht von der Betätigungsfläche 5 des Verriegelungselements 4 absteht. Der Gleit- und Arretierungskörper 6 weist zwei an den seitlichen Öffnungsrändern 32, 33 der Öffnung 30 in der Abdeckhaube 3 anliegende Seitenwände auf, die durch einen Freischnitt federnde Zungen bzw. bewegliche Wandabschnitte 61, 62 ausbilden, an denen Rastvorsprünge 63, 64 vorgesehen sind, die zum unteren Ende des Gleit- und Arretierungskörpers 6 gerichtete Schrägflächen und eine senkrecht von den beweglichen Wandabschnitten 61, 62 abstehende Arretierungsfläche aufweisen.

Beim Einsetzen des Verriegelungselements 4 in die Öffnung 30 der Abdeckhaube 3 gleiten die beweglichen Wandabschnitte 61, 62 an den seitlichen Öffnungsrändern 32, 33 der Öffnung 30 entlang, werden beim Erreichen der Rastvorsprünge 63, 64 in den Innenraum des Gleit- und Arretierungskörpers 6 gedrückt und springen federnd zurück, wenn das Ende der Rastvorsprünge 63, 64 erreicht ist und damit der Innenrand der seitlichen Öffnungsränder 32, 33 an Gleitstegen 65, 66 der beweglichen Wandabschnitte 61, 62 anliegt. In dieser Positionierung ist das Verriegelungselement 4 formschlüssig mit dem Wandabschnitt der Abdeckhaube 3 im Bereich der Öffnung 30 bzw. der Vertiefung 31 verbunden. Diese Verbindung kann lediglich durch gleichzeitiges Hereindrücken beider beweglicher Wandabschnitte 61, 62 in den Innenraum des Gleit- und Arretierungskörpers 6 gelöst werden.

Nach der formschlüssigen Verbindung des Verriegelungselements 4 mit der Seitenwand der Abdeckhaube 3 kann das Verriegelungselement 4 in Längsrichtung innerhalb der Vertiefung oder Mulde 31 der Seitenwand der Abdeckhaube 3 verschoben werden, wobei die Gleitstege 65, 66 jeweils rastend in die Einkerbungen 34, 35 der seitlichen Öffnungsränder 32, 33 eingreifen, wenn eine Endstellung der Betätigungsfläche 5 des Verriegelungselements 4 in Bezug auf die Vertiefung oder Mulde 31 erreicht ist bzw. wenn eine der beiden Stirnkanten des Gleit- und Arretierungskörpers 6 an den entsprechenden stirnseitigen Öffnungsrand der Öffnung 30 anstößt.

Das in die Betätigungsfläche 5 des Verriegelungselements 4 eingesetzte Sperrelement 7 kann in den durch die Endanschläge des Verstellbereichs 55 vorgegebenen Grenzen, in denen eine der beiden Nasen 81, 82 an der Unterseite des Verstellteils 8 des Sperrelements 7 gegen die senkrechte Fläche 571 des Steges 57 bzw. die nicht näher bezifferte senkrechte Fläche der Erhebung 502 stößt, verstellt werden.

Ein verriegeln des Verriegelungselements 4 zum Blockieren von dessen Längsverschiebung ist jedoch nur dann möglich, wenn die Verriegelungsstellung des Verriegelungselements 4 erreicht ist und die Gleitstege 65, 66 in die entsprechende Einkerbung 34, 35 in den seitlichen Öffnungsrändern 32, 33 der Öffnung 30 einrasten. Nur in dieser Stellung können die Klemmstege 91, 92 des Sperrelements 7 so weit gegen die Innenflächen des Gleit- und Arretierungskörpers 6 gedrückt werden, dass die Nase 81 bzw. 82 den nockenartigen Vorsprung 59 überwindet und damit das verriegelungselement 4 in der Verriegelungsstellung blockiert.

In gleicher Weise ist das Erreichen der Entriegelungsstellung, in der sich die Nase 81 bzw. 82 zwischen der nockenförmigen Erhebung 58 und der senkrechten Wandfläche 571 des Steges 57 befindet, nur dann herstellbar, wenn sich das Verriegelungselement 4 in einer Stellung befindet, in der die Gleitstege 65, 66 in die entsprechend anderen Einkerbungen 34, 35 der seitlichen Öffnungsränder 32, 33 der Öffnung 30 einrasten.

Zur optischen Erkennbarkeit der jeweiligen Entriegelungs- oder Verriegelungsstellung kann auch der Betätigungsschlitz 80 in der Verstellfläche 8 des Sperrelements 7 dienen, der in der Entriegelungsstellung mit der Längsausrichtung der Betätigungsfläche 5 des Verriegelungselements 4 fluchtet und in der Verriegelungsstellung senkrecht hierzu verläuft.

Zum Verdrehen des Sperrelements 7 kann beispielsweise eine Münze in den Betätigungsschlitz 80 eingesteckt werden, so daß keine Spezialwerkzeuge für die Verriegelung und das Sperren der Verriegelung zwischen der Abdeckhaube 3 und dem Gehäuseboden 2 erforderlich sind. Anstelle eines Betätigungsschlitzes 80 kann auch ein entsprechender, von der Verstellfläche 8 abstehender Steg dienen, so daß das Sperrelement 7 mit Daumen und Zeigefinder verdreht werden kann.

Die Erfindung beschränkt sich in ihrer Ausführung nicht auf die vorstehend angegebenen bevorzugten Ausführungsbeispiele, sondern es ist eine Anzahl von Varianten innerhalb des von den Ansprüchen definierten Bereichs denkbar.

## Patentansprüche

1. Mehrteiliges Gehäuse mit einer Vorrichtung zum Verriegeln von miteinander verbundenen Gehäuseteilen des mehrteiligen Gehäuses für elektrische und elektronische Bauelemente
- mit einem Verriegelungselement (4),
- das in Längsrichtung verschiebbar, formschlüssig in eine schlitzförmige Öffnung (30) eines ersten Gehäuseteils (3) eingesetzt ist, wobei die Öffnung (30) im Wesentlichen parallel zueinander in Verschieberichtung des Verriegelungselements (4) verlaufende seitliche Öffnungsränder (32, 33) aufweist,
- das eine an der Außenwand des ersten Gehäuseteils (3) anliegende Betätigungsfläche (5) und einen Gleit- und Arretierungskörper (6) aufweist, der die schlitzförmige Öffnung (30) durchgreift, und
- das in einer (3) Verriegelungsstellung das erste Gehäuseteil (3) mit mindestens einem zweiten Gehäuseteil (2) form- und/oder kraftschlüssig verbindet und in einer Entriegelungsstellung die Verbindung zwischen dem ersten und zweiten Gehäuseteil (3, 2) löst, insbesondere zum Verbinden einer Haube (3) mit einem Gehäuseunterteil (2) einer Telekommunikationsanlage, und
- mit einem mit dem Verriegelungselement (4) verbundenen Sperrelement (7), das die Verstellbarkeit des Verriegelungselementes (4) zumindest in der Verriegelungsstellung blockiert,
**dadurch gekennzeichnet,**
- **dass** der Gleit- und Arretierungskörper (6) als Hohlkörper mit Gleitelementen (65, 66) ausgebildet ist,
- **dass** die Gleitelemente (65, 66) an den seitlichen Öffnungsrändern (32, 33) der Öffnung (30) anliegen und Teil von Wandabschnitten (61, 62) des Gleit-und Arretierungskörpers (6) sind, die parallel zu den seitlichen Öffnungsrändern (32, 33) der Öffnung (30) verlaufen und senkrecht zur Verschieberichtung beweglich sind, und
- **dass** das in das Verriegelungselement (4) eingesetzte Sperrelement (7) in der Verriegelungsstellung die Gleitelemente (65, 66) der beweglichen Wandabschnitte (61, 62) kraftschlussig zur Anlage an die seitlichen Öffnungsränder (32, 33) bringt.

2. Mehrteiliges Gehäuse nach Anspruch 1, **dadurch gekennzeichnet, dass** die beweglichen Wandabschnitte (61, 62) des Gleit- und Arretierungskörpers (6) mit Rastvorsprüngen (63, 64) derart versehen sind, dass beim Einstecken des Gleit- und Arretierungskörpers (6) in die Öffnung (30) des ersten Gehäuseteils (3) die beweglichen Wandabschnitte (61, 62) an den seitlichen öffnungsrändern (32, 33) entlanggleiten und nach dem Überwinden der Rastvorsprünge (63, 64) das Verriegelungselement (4) formschlüssig mit dem ersten Gehäuseteil (3) verbunden ist und die Gleitelemente (65, 66) an den seitlichen öffnungsrändern (32, 33) anliegen.

3. Mehrteiliges Gehäuse nach mindestens einem der voranstehenden Ansprüche, **dadurch gekennzeichnet, dass** die Gleitelemente als Gleitstege (65, 66) ausgebildet sind, die in vorgegebenen Stellungen des Verriegelungselements (4) in Einkerbungen (34, 35) der seitlichen Öffnungsränder (32, 33) der Öffnung (30) im ersten Gehäuseteil (3) einrasten.

4. Mehrteiliges Gehäuse nach Anspruch 3, **dadurch gekennzeichnet, dass** die Gleitstege (65, 66) in der Mitte des Verriegelungselements (4) und die Einkerbungen (34, 35) so in den seitlichen Öffnungsrändern (32, 33) angeordnet sind, dass die Gleitstege (65, 66) in der Verriegelungs- und Entriegelungsstellung des Verriegelungselements (4) in die Einkerbungen (34, 35) einrasten.

5. Mehrteiliges Gehäuse nach mindestens einem der voranstehenden Ansprüche, **gekennzeichnet durch** ein in die Betätigungsfläche (5) des Verriegelungselements (4) integriertes Verstellteil (8) des als Drehriegel ausgebildeten Sperrelements (7) und eine senkrecht von dem Verstellteil (8) abstehende Drehachse (9) mit seitlichen, **durch** Verdrehen des Verstellteils (8) in Anlage an die beweglichen Wandabschnitte (61, 62) des Gleit- und Arretierungskörpers (6) des Verriegelgungselements (4) bringbaren Klemmstegen (91, 92).

6. Mehrteiliges Gehäuse nach Anpruch 5, **dadurch gekennzeichnet, dass** das Verstellteil (8) nur dann in die Verriegelungs- und Entriegelungsstellung bringbar ist, wenn die Gleitstege (65, 66) in eine der Einkerbungen (34, 35) der seitlichen Öffnungsränder (32, 33) der Öffnungen (30) des ersten Gehäuseteils (3) eingerastet sind.

7. Mehrteiliges Gehäuse nach Anspruch 5, **dadurch gekennzeichnet, dass** die Betätigungsfläche (5) des Verriegelungselements (4) in eine Vertiefung (31) des an die Öffnung (30) angrenzenden Wandabschnitts des ersten Gehäuseteils (3) eingesetzt ist.

8. Mehrteiliges Gehäuse nach mindestens einem der voranstehenden Ansprüche 5 bis 7, **dadurch gekennzeichnet, dass** die Betätigungsfläche (5) des Verriegelungselements (4) eine Vertiefung (50) zur Aufnahme des kreisscheibenförmig ausgebildeten und mit einem mittig angeordneten Betätigungsschlitz oder -steg (80) versehenen Verstellteils (8) des Sperrelements (7) aufweist.

9. Mehrteiliges Gehaüse nach mindestens einem der voranstehenden Ansprüche 5 bis 7, **dadurch gekennzeichnet, dass** die Betätigungsfläche (5) des Verriegelungselements (4) eine Schlüssellochöffnung (53) zur Aufnahme der Drehachse (9) und der Klemmstege (91, 92) des Sperrelements (7) aufweist.

10. Mehrteiliges Gehäuse nach Anspruch 9, **dadurch gekennzeichnet, dass** die Schlüssellochöffnung (53) diagonal zu den beweglichen Wandabschnitten (61, 62) des Verriegelungselements (4) ausgerichtet ist.

11. Mehrteiliges Gehäuse nach mindestens einem der voranstehenden Ansprüche 5 bis 10, **dadurch gekennzeichnet, dass** die Unterseite des Verstellteils (8) mindestens eine mit den entgegengesetzt zueinander von der Drehachse (9) abstehenden Klemmstegen (91, 92) fluchtende Nase (81, 82) aufweist und dass die Vertiefung (50) der Betätigungsfläche (5) zur Aufnahme des Verstellteils (8) eine teilkreisförmige Nut (54, 55) enthält, in die die Nase (81, 82) an der Unterseite des Verstellteils (8) eingreift.

12. Mehrteiliges Gehäuse nach den Ansprüchen 11 und 9, **dadurch gekennzeichnet, dass** die Klemmstege (91, 92) des Sperrelements (7) zumindest um das Maß der Tiefe der Schlüssellochöffnung (53) der Betätigungsfläche (5) von der Unterseite des Verstellteils (8) beabstandet sind.

13. Mehrteiliges Gehäuse nach den Ansprüchen 9 und 11 oder 12, **dadurch gekennzeichnet, dass** in der teilkreisförmigen Nut (54, 55) ein Steg (57) angeordnet ist, der die teilkreisförmige Nut (54, 55) in einen mit der Schlüssellochöffnung (53) im Wesentlichen fluchtenden Einsetzbereich (54) für die Nase (81, 82) und einen Verstellbereich (55) für das Sperrelement (7) unterteilt.

14. Mehrteiliges Gehäuse nach Anspruch 13, **dadurch gekennzeichnet, dass** der Steg (57) eine dem Einsetzbereich (54) zugewandte Schrägfläche (570) und eine dem Verstellbereich (55) zugewandte senkrechte Fläche (571) aufweist, derart, dass nach dem Einsetzen des Sperrelements (7) in das Verriegelungselement (4) und dem Überwinden des Steges (57) das Sperrelement (7) um das Winkelmaß des Verstellbereiches (55) zwischen der Verriegelungs- und der Entriegelungsstellung verstellbar ist.

15. Mehrteiliges Gehäuse nach Anspruch 14, **dadurch gekennzeichnet, dass** die Verriegelungs- und die Entriegelungsstellung durch abgerundete Vorsprünge (58, 59) innerhalb des Verstellbereiches (55) festgelegt sind.

16. Mehrteiliges Gehäuse nach mindestens einem der voranstehenden Ansprüche 11 bis 15, **dadurch gekennzeichnet, dass** eine zweite teilkreisförmige Nut (56) durch Trennstege (501, 502) von der ersten teilkreisförmigen Nut (54, 55) getrennt als durchgehende Vertiefung zur Aufnahme einer diametral zu einer ersten Nase (81) angeordneten zweiten Nase (82) an der Unterseite des Verstellteils (8) ausgebildet ist.

17. Mehrteiliges Gehäuse nach mindestens einem der voranstehenden Ansprüche 8 bis 16, **gekennzeichnet durch** an die Vertiefung (50) zur Aufnahme des Verstellteils (8) des Sperrelements (7) angrenzende Fingermulden (51, 52) in der Betätigungsfläche (5) des Verriegelungselements (4).

## Claims

1. Multi-part housing having an apparatus for locking housing parts, which are connected to one another, of the multi-part housing for electrical and electronic components
- having a locking element (4),
- which is inserted into a slot-shaped opening (30) in a first housing part (3) in an interlocking manner and such that it can be displaced in the longitudinal direction, the opening (30) having lateral opening edges (32, 33) extending essentially parallel to one another in the displacement direction of the locking element (4),
- which has an actuating face (5), which bears against the outer wall of the first housing part (3), and a sliding and retaining body (6), which passes through the slot-shaped opening (30), and
- which, in a locking position, connects the first housing part (3) to at least one second housing part (2) in an interlocking and/or force-fitting manner and, in an unlocking position, releases the connection between the first and the second housing parts (3, 2), in particular for the purpose of connecting a cover (3) to a lower housing part (2) of a telecommunications system, and
- having a blocking element (7), which is connected to the locking element (4) and blocks the ability of the locking element (4) to be displaced at least in the locking position,
**characterized**
- **in that** the sliding and retaining body (6) is in the form of a hollow body with sliding elements (65, 66),
- **in that** the sliding elements (65, 66) bear against the lateral opening edges (32, 33) of the opening (30) and are part of wall sections (61, 62) of the sliding and retaining body (6) which extend parallel to the lateral opening edges (32, 33) of the opening (30) and can be moved perpendicularly with respect to the displacement direction, and
- **in that**, in the locking position, the blocking element (7) inserted into the locking element (4) brings the sliding elements (65, 66) of the moving wall sections (61, 62) to bear in a force-fitting manner against the lateral opening edges (32, 33).

2. Multi-part housing according to Claim 1, **characterized in that** the moving wall sections (61, 62) of the sliding and retaining body (6) are provided with latching projections (63, 64) such that, when the sliding and retaining body (6) is inserted into the opening (30) in the first housing part (3), the moving wall sections (61, 62) slide along the lateral opening edges (32, 33) and, once the latching projections (63, 64) have been overcome, the locking element (4) is connected in an interlocking manner to the first housing part (3), and the sliding elements (65, 66) bear against the lateral opening edges (32, 33).

3. Multi-part housing according to at least one of the preceding claims, **characterized in that** the sliding elements are in the form of sliding webs (65, 66) which latch into notches (34, 35) in the lateral opening edges (32, 33) of the opening (30) in the first housing part (3) in predetermined positions of the locking element (4).

4. Multi-part housing according to Claim 3, **characterized in that** the sliding webs (65, 66) are arranged in the centre of the locking element (4), and the notches (34, 35) are arranged in the lateral opening edges (32, 33) such that the sliding webs (65, 66) latch into the notches (34, 35) in the locking position and the unlocking position of the locking element (4).

5. Multi-part housing according to at least one of the preceding claims, **characterized by** a displacement part (8), which is integrated in the actuating face (5) of the locking element (4), of the blocking element (7) in the form of a rotary catch and a rotary shaft (9), which protrudes perpendicularly from the displacement part (8), having lateral clamping webs (91, 92), which can be brought to bear against the moving wall sections (61, 62) of the sliding and retaining body (6) of the locking element (4) by the displacement part (8) being rotated.

6. Multi-part housing according to Claim 5, **characterized in that** the displacement part (8) can only be brought into the locking position and the unlocking position when the sliding webs (65, 66) are latched into one of the notches (34, 35) in the lateral opening edges (32, 33) of the openings (30) in the first housing part (3).

7. Multi-part housing according to Claim 5, **characterized in that** the actuating face (5) of the locking element (4) is inserted into a depression (31) in the wall section, which adjoins the opening (30), of the first housing part (3).

8. Multi-part housing according to at least one of the preceding Claims 5 to 7, **characterized in that** the actuating face (5) of the locking element (4) has a depression (50) for the purpose of accommodating the displacement part (8) of the blocking element (7), which displacement part (8) is in the form of a circular disc and is provided with a centrally arranged actuating slot or web (80).

9. Multi-part housing according to at least one of the preceding Claims 5 to 7, **characterized in that** the actuating face (5) of the locking element (4) has a keyhole opening (53) for the purpose of accommodating the rotary shaft (9) and the clamping webs (91, 92) of the blocking element (7).

10. Multi-part housing according to Claim 9, **characterized in that** the keyhole opening (53) is aligned diagonally with respect to the moving wall sections (61, 62) of the locking element (4).

11. Multi-part housing according to at least one of the preceding Claims 5 to 10, **characterized in that** the underside of the displacement part (8) has at least one tab (81, 82), which is aligned with the clamping webs (91, 92) protruding opposite one another from the rotary shaft (9), and **in that** the depression (50) in the actuating face (5) for the purpose of accommodating the displacement part (8) contains a semicircular groove (54, 55), into which the tab (81, 82) on the underside of the displacement part (8) engages.

12. Multi-part housing according to Claims 11 and 9, **characterized in that** the clamping webs (91, 92) of the blocking element (7) are at a distance from the underside of the displacement part (8) which is at least the degree of depth of the keyhole opening (53) in the actuating face (5).

13. Multi-part housing according to Claims 9 and 11 or 12, **characterized in that** a web (57) is arranged in the semicircular groove (54, 55) and divides the semicircular groove (54, 55) into a recess region (54), which is essentially aligned with the keyhole opening (53), for the tab (81, 82) and a displacement region (55) for the blocking element (7).

14. Multi-part housing according to Claim 13, **characterized in that** the web (57) has a sloping face (570), which faces the recess region (54), and a perpendicular face (571), which faces the displacement region (55), with the result that, once the blocking element (7) has been inserted into the locking element (4) and the web (57) has been overcome, the blocking element (7) can be displaced between the locking position and the unlocking position by the angular degree of the displacement region (55).

15. Multi-part housing according to Claim 14, **characterized in that** the locking position and the unlocking position are fixed by rounded projections (58, 59) within the displacement region (55).

16. Multi-part housing according to at least one of the preceding Claims 11 to 15, **characterized in that** a second semicircular groove (56), separated from the first semicircular groove (54, 55) by separating webs (501, 502), is in the form of a continuous depression for the purpose of accommodating a second tab (82), which is arranged diametrically with respect to a first tab (81), on the underside of the displacement part (8).

17. Multi-part housing according to at least one of the preceding Claims 8 to 16, **characterized by** finger troughs (51, 52), which adjoin the depression (50) for the purpose of accommodating the displacement part (8) of the blocking element (7), in the actuating face (5) of the locking element (4).

## Revendications

1. Boîtier en plusieurs parties comprenant un dispositif pour le verrouillage de parties de boîtier connectées les unes aux autres du boîtier en plusieurs parties pour des composants électriques et électroniques,
- avec un élément de verrouillage (4),
- qui est inséré de manière déplaçable dans la direction longitudinale, par engagement par coopération de forme dans une ouverture (30) en forme de fente d'une première partie de boîtier (3), l'ouverture (30) présentant des bords d'ouverture (32, 33) latéraux s'étendant essentiellement parallèlement l'un à l'autre dans la direction du déplacement de l'élément de verrouillage (4),
- qui présente une surface d'actionnement (5) s'appliquant contre la paroi extérieure de la première partie de boîtier (3) et un corps de glissement et de blocage (6), qui vient en prise à travers l'ouverture (30) en forme de fente, et
- qui relie, dans une position de verrouillage, la première partie de boîtier (3) à au moins une deuxième partie de boîtier (2) par engagement par coopération de forme et/ou par force et qui, dans une position de déverrouillage, libère la connexion entre la première et la deuxième partie de boîtier (3, 2), notamment pour relier un capot (3) à une partie inférieure du boîtier (2) d'une installation de télécommunications et
- avec un élément de blocage (7) relié à l'élément de verrouillage (4), qui bloque la possibilité de déplacement de l'élément de verrouillage (4) au moins dans la position de verrouillage,
**caractérisé**
- **en ce que** le corps de glissement et de blocage (6) est réalisé sous forme de corps creux avec des éléments de glissement (65, 66),
- **en ce que** les éléments de glissement (65, 66) s'appliquent contre les bords d'ouverture latéraux (32, 33) de l'ouverture (30) et font partie de portions de paroi (61, 62) du corps de glissement et de blocage (6) qui s'étendent parallèlement aux bords d'ouverture latéraux (32, 33) de l'ouverture (30) et qui peuvent se déplacer perpendiculairement à la direction de déplacement, et
- **en ce que** l'élément de blocage (7) inséré dans l'élément de verrouillage (4) dans la position de verrouillage amène les éléments de glissement (65, 66) des portions de paroi mobiles (61, 62) par engagement par force en appui contre les bords d'ouverture latéraux (32, 33).

2. Boîtier en plusieurs parties selon la revendication 1, **caractérisé en ce que** les portions de paroi mobiles (61, 62) du corps de glissement et de blocage (6) sont pourvues de saillies d'encliquetage (63, 64) de telle sorte que lors de l'insertion du corps de glissement et de blocage (6) dans l'ouverture (30) de la première partie de boîtier (3), les portions de paroi mobiles (61, 62) glissent le long des bords d'ouverture latéraux (32, 33) et après avoir surmonté les saillies d'encliquetage (63, 64), l'élément de verrouillage (4) est connecté par engagement par coopération de forme avec la première partie de boîtier (3) et les éléments de glissement (65, 66) s'appliquent contre les bords d'ouverture latéraux (32, 33).

3. Boîtier en plusieurs parties selon au moins l'une quelconque des revendications précédentes, **caractérisé en ce que** les éléments de glissement sont réalisés en tant que nervures de glissement (65, 66) qui s'encliquètent dans des positions prédéfinies de l'élément de verrouillage (4) dans des entailles (34, 35) des bords d'ouverture latéraux (32, 33) de l'ouverture (30) dans la première partie de boîtier (3).

4. Boîtier en plusieurs parties selon la revendication 3, **caractérisé en ce que** les nervures de glissement (65, 66) sont disposées au milieu de l'élément de verrouillage (4) et les entailles (34, 35) sont disposées dans les bords d'ouverture latéraux (32, 33) de telle sorte que les nervures de glissement (65, 66) s'encliquètent dans les entailles (34, 35) dans la position de verrouillage et de déverrouillage de l'élément de verrouillage (4).

5. Boîtier en plusieurs parties selon au moins l'une quelconque des revendications précédentes, **caractérisé par** une partie de déplacement (8) de l'élément de blocage (7) réalisé sous forme de verrou tournant intégrée dans la surface d'actionnement (5) de l'élément de verrouillage (4) et par un axe de rotation (9) saillant perpendiculairement depuis la partie de déplacement (8), avec des nervures de serrage (91, 92) latérales, pouvant être amenées par rotation de la partie de déplacement (8) en appui contre les portions de paroi mobiles (61, 62) du corps de glissement et de blocage (6) de l'élément de verrouillage (4).

6. Boîtier en plusieurs parties selon la revendication 5, **caractérisé en ce que** la partie de déplacement (8) ne peut être amenée dans la position de verrouillage et de déverrouillage que lorsque les nervures de glissement (65, 66) sont encliquetées dans l'une des entailles (34, 35) des bords d'ouverture latéraux (32, 33) des ouvertures (30) de la première partie de boîtier (3).

7. Boîtier en plusieurs parties selon la revendication 5, **caractérisé en ce que** la surface d'actionnement (5) de l'élément de verrouillage (4) est insérée dans un renfoncement (31) de la portion de paroi de la première partie de boîtier (3) adjacente à l'ouverture (30).

8. Boîtier en plusieurs parties selon au moins l'une quelconque des revendications précédentes 5 à 7, **caractérisé en ce que** la surface d'actionnement (5) de l'élément de verrouillage (4) présente un renfoncement (50) pour recevoir la partie de déplacement (8) de l'élément de blocage (7) réalisée en forme de disque circulaire et pourvue d'une fente ou d'une nervure d'actionnement (80) disposée centralement.

9. Boîtier en plusieurs parties selon au moins l'une quelconque des revendications précédentes 5 à 7, **caractérisé en ce que** la surface d'actionnement (5) de l'élément de verrouillage (4) présente une ouverture de trou de serrure (53) pour recevoir l'axe de rotation (9) et les nervures de serrage (91, 92) de l'élément de blocage (7).

10. Boîtier en plusieurs parties selon la revendication 9, **caractérisé en ce que** l'ouverture de trou de serrure (53) est orientée en diagonale par rapport aux portions de paroi mobiles (61, 62) de l'élément de verrouillage (4).

11. Boîtier en plusieurs parties selon au moins l'une quelconque des revendications précédentes 5 à 10, **caractérisé en ce que** le côté inférieur de la partie de déplacement (8) présente au moins un nez (81, 82) en affleurement avec les nervures de serrage (91, 92) saillant de manière opposée depuis l'axe de rotation (9), et **en ce que** le renfoncement (50) de la surface d'actionnement (5) contient une rainure (54, 55) en forme de cercle partiel pour recevoir la partie de déplacement (8), dans laquelle rainure le nez (81, 82) vient en prise contre le côté inférieur de la partie de déplacement (8).

12. Boîtier en plusieurs parties selon les revendications 11 et 9, **caractérisé en ce que** les nervures de serrage (91, 92) de l'élément de blocage (7) sont au moins espacées de la dimension de la profondeur de l'ouverture de trou de serrure (53) de la surface d'actionnement (5) du côté inférieur de la partie de déplacement (8).

13. Boîtier en plusieurs parties selon les revendications 9 et 11 ou 12, **caractérisé en ce que** l'on dispose dans la rainure en forme de cercle partiel (54, 55) une nervure (57) qui divise la rainure en forme de cercle partiel (54, 55) en une région d'insertion (54) essentiellement en affleurement avec l'ouverture de trou de serrure (53), pour le nez (81, 82), et une région de déplacement (55) pour l'élément de blocage (7).

14. Boîtier en plusieurs parties selon la revendication 13, **caractérisé en ce que** la nervure (57) présente une surface oblique (570) tournée vers la région d'insertion (54) et une surface (571) perpendiculaire tournée vers la région de déplacement (55), de telle sorte qu'après l'insertion de l'élément de blocage (7) dans l'élément de verrouillage (4) et après que la nervure (57) a été surmontée, l'élément de blocage (7) peut être déplacé de la mesure angulaire de la région de déplacement (55) entre la position de verrouillage et la position de déverrouillage.

15. Boîtier en plusieurs parties selon la revendication 14, **caractérisé en ce que** la position de verrouillage et la position de déverrouillage sont fixées par des saillies arrondies (58, 59) à l'intérieur de la région de déplacement (55).

16. Boîtier en plusieurs parties selon au moins l'une quelconque des revendications précédentes 11 à 15, **caractérisé en ce qu'**une deuxième rainure en forme de cercle partiel (56) est séparée par des nervures de séparation (501, 502) de la première rainure en forme de cercle partiel (54, 55) sous forme de renfoncement continu pour recevoir un deuxième nez (82) disposé diamétralement par rapport au premier nez (81) sur le côté inférieur de la partie de déplacement (8).

17. Boîtier en plusieurs parties selon au moins l'une quelconque des revendications précédentes 8 à 16, **caractérisé par** des creux pour les doigts (51, 52) adjacents au renfoncement (50) pour recevoir la partie de déplacement (8) de l'élément de blocage (7), dans la surface d'actionnement (5) de l'élément de verrouillage (4).
